# EUROPÄISCHE PATENTANMELDUNG

(11) **EP 1 172 934 A2**
(43) Veröffentlichungstag der Anmeldung: **16.01.2002**
(21) Anmeldenummer: 01116419.1
(22) Anmeldetag: 06.07.2001
(51) Int. Cl.: H03K 17/0814

(54) **Schaltungsanordnung zum Schalten von induktiven Lasten**

(30) Priorität: 12.07.2000 EP 00114878
(71) Anmelder: Tyco Electronics AMP GmbH, 64625 Bensheim (DE)
(72) Erfinder: Bruck, Jürgen, 12525 Berlin (DE)
(74) Vertreter: Heinz-Schäfer, Marion

(57) **Zusammenfassung**

Die vorgeschlagene Schaltungsanordnung dient zur Schaltung induktiver Lasten. Die Schaltung ist insbesondere für hohe Frequenzen und Ströme geeignet, beispielsweise bei Pulsbreiten-Modulation. Parallel zu einer Lastinduktivität (L1) ist eine Freilaufdiode (D1) geschaltet, die um eine in Serie geschaltete zweite Induktivität (L2) ergänzt ist. Beim Abschalten des Laststromes durch einen ersten Halbleiterschalter (S1) kommutiert der Strom in eine erste Kapazität (C1), gleichzeitig wird die zweite Induktivität (L2) durch einen negativ vorgespannten zweiten Kondensator (C2) aufgeladen, wozu ein zweiter Halbleiterschalter (S2) zwischen die zweite Induktivität (L2) und den zweiten Kondensator (C2) geschaltet ist. Der zweite Schalter (S2) ist über eine Steuereinheit so gesteuert, daß er bei Sperren des Schalters (S1) leitend wird und bei Unterschreiten eines vorgegebenen Schwellwertes des Stromes durch die Freilaufdiode (D1) wieder sperrt. Parallel zum zweiten Kondensator (C2) befindet sich eine Reihenschaltung aus einer zweiten Diode (D2) und einer dritten Induktivität (L3).

## Beschreibung

Die Erfindung betrifft eine Schaltungsanordnung zum Schalten von induktiven Lasten mit einem ersten und einem zweiten Versorgungspotential, einem ersten Halbleiterschalter, der mit dem zweiten Versorgungspotential verbunden ist, einer ersten eine Last bildenden Induktivität, die zwischen dem ersten Halbleiterschalter und dem ersten Versorgungspotential liegt, und einem Parallelzweig zu der ersten Induktivität, der eine erste Diode aufweist, deren Kathode zu dem Versorgungspotential geschaltet ist, das gegenüber dem anderen Versorgungspotential eine positive Spannung aufweist.

Beim Abschalten einer induktiven Last ändert sich der Stromfluß nicht abrupt, sondern die Induktivität erhält einen Strom, den sogenannten Abmagnetisierungsstrom, solange aufrecht, bis die in der induktiven Last gespeicherte Energie entladen ist. Dieser erzwungene Stromfluß erfolgt über oft unerwünschte Pfade und hat u.U. nachteilige Wirkungen. Bei mechanischen Schaltern wird durch diesen Stromfluß beispielsweise ein Lichtbogen erzeugt, der hochfrequente Störungen im Versorgungsnetz zur Folge hat. Außerdem stellt ein Lichtbogen eine hohe thermische Belastung für die mechanischen Kontakte dar. Beim Abschalten induktiver Lasten mit Halbleiter-Schaltern, insbesondere mit MOS-Transistoren, fließt zumindest ein Teil des Stromes über die Drain-Gate-Kapazität des Transistors und den Innenwiderstand der Treiberschaltung ab. Wenn der Innenwiderstand des Treibers zu groß ist, wird der Spannungsabfall so groß, daß die Gate-Schwellspannung des MOS-Transistors überschritten wird und der Transistor nicht oder nur ungenügend sperrt. Darüber hinaus erzeugt der unerwünschte Strom die bekannten Abschalt-Verluste im Halbleiter. Diese Verluste steigen mit der Frequenz und dem Laststrom erheblich an, so daß durch die erzeugte Wärme eine Gefahr für den Halbleiter gegeben ist.

Außerdem wird durch diese Erwärmung auch der Einschaltwiderstand eines Halbleiterschalters erhöht, was wiederum die Leitverluste ansteigen läßt.

Eine Schaltungsanordnung der eingangs genannten Art ist beispielsweise aus "Nührmann, Dieter: Das große Werkbuch Elektronik, Franzis-Verlag München, 1989" bekannt. Die dort gezeigte Schaltungsanordnung dient der Steuerung einer Relais-Spule über einen Transistor. Eine Diode ist mit der Kathode an einen Pluspol einer Spannungsversorgung parallel zu einer Relais-Spule geschaltet. Relais werden mit einer relativ kleinen Wiederholfrequenz geschaltet. Bei Anwendungen, bei denen die Schaltfrequenz stark zunimmt, steigen die Verluste im Transistor jedoch stark an. Ein Anwendungsbeispiel für diesen Fall sind pulsbreitenmodulierte Steuerungen induktiver Lasten. Insbesondere in einer nicht-lückenden Betriebsweise, d.h. wenn der Schalter wieder leitend wird, bevor der Strom in der Freilaufdiode zu Null geworden ist, muß der Schalter neben dem eigentlichen Laststrom den momentan in der Freilaufdiode fließenden Strom übernehmen, wobei die volle Betriebsspannung und der Ausräumstrom der Freilaufdiode gleichzeitig den Schalter belasten.

Aufgabe der Erfindung ist es daher, eine Schaltungsanordnung zur Schaltung von induktiven Lasten anzugeben, bei der die Verlustleistung im Halbleiterschalter erheblich geringer ist.

Diese Aufgabe wird erfindungsgemäß durch eine Schaltungsanordnung der eingangs genannten Art gelöst, die dadurch gekennzeichnet ist, der Parallelzweig eine zweite Induktivität aufweist, die in Reihe zu der ersten Diode geschaltet ist und mit dem Verbindungspunkt der ersten Induktivität mit dem ersten Schalter verbunden ist, an der Verbindungsstelle zwischen der ersten und der zweiten Induktivität eine erste kapazitive Anordnung angekoppelt ist, die mit dem zweiten Versorgungspotential verbunden ist, an der Verbindungsstelle zwischen der zweiten Induktivität und der ersten Diode ein zweiter Halbleiterschalter angeschlossen ist, der über eine Anordnung, die eine zweite Kapazität und parallel dazu eine Reihenschaltung aus einer zweiten Diode und einer dritten Induktivität aufweist, mit dem zweiten Versorgungspotential verbunden ist, und einer Steuereinheit, die den zweiten Schalter halbsynchron mit dem ersten Schalter derart steuert, daß der zweite Schalter leitend wird, wenn der erste Schalter sperrt, und leitend bleibt, bis der Strom durch die erste Diode einen vorbestimmten Schwellwert nahe Null unterschreitet.

Die erfindungsgemäße Schaltungsanordnung ist vorteilhaft, weil der erste Halbleiterschalter weder mit Spannungserhöhungen durch eine induzierte Spannung an der ersten Induktivität noch mit dem Strom durch die Freilaufdiode belastet wird.

Weiterhin ist vorteilhaft, daß der Energiebedarf für die zweite Induktivität selbsttätig der Schaltfrequenz des ersten Halbleiterschalters angepaßt ist.

In einer vorteilhaften Ausgestaltung der Erfindung ist die erste Kapazität mit einer Schaltung zur Energierückgewinnung verbunden. In einer solchen Ausführung wird die in der Kapazität zwischengespeicherte Energie in die Hauptenergiequelle zurückgespeist.

Weitere Einzelheiten und Ausgestaltungen der Erfindung sind in den Unteransprüchen angegeben.

Die Erfindung wird nachfolgend an einem Ausführungsbeispiel anhand der Zeichnungen näher erläutert. Es zeigt:
- Figur 1: eine Schaltungsanordnung aus dem Stand der Technik,
- Figur 2: ein Ausführungsbeispiel einer erfindungsgemäßen Schaltungsanordnung und
- Figur 3: Strom- und Spannungsverläufe der Schaltungsanordnung von Figur 2.

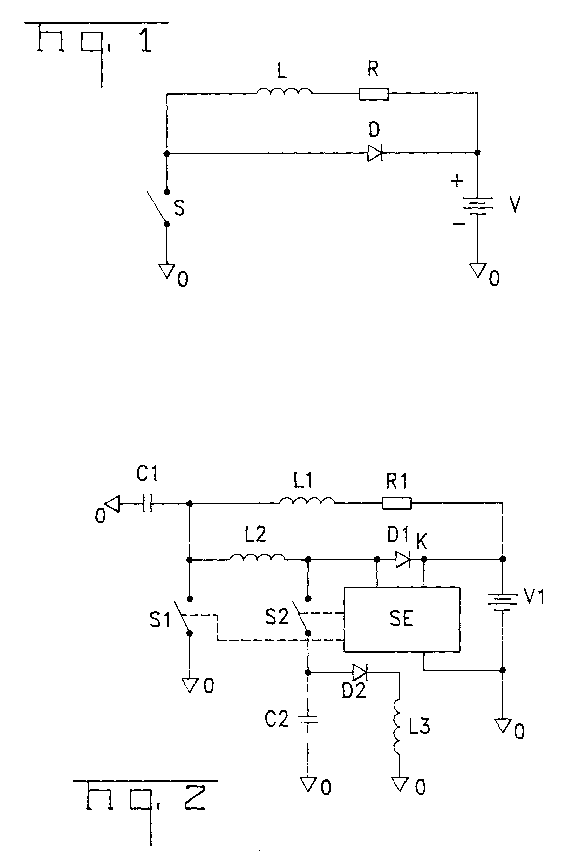

Die Figur 1 zeigt eine Schaltungsanordnung zum Schalten induktiver Lasten, wie sie aus dem Stand der Technik bekannt ist. Das Prinzip der eingangs zitierte Schaltungsanordnung zum Schalten einer Relais-Spule entspricht dieser Schaltungsanordnung. Ein Schalter S ist allgemein als Schalter dargestellt; in Anwendungsfällen, in denen die vorliegende Erfindung von Interesse ist, wird dies ein Halbleiterschalter sein, beispielsweise ein MOS-Transistor. Eine induktive Last ist durch eine Induktivität L und einen Widerstand R dargestellt, dem üblichen Serien-Ersatzschaltbild für eine induktive Last. Spulen, gleich welcher Art, haben immer einen induktiven und einen resistiven Anteil, wobei der resistive Anteil in den meisten Fällen vernachlässigt werden kann. Beim Sperren des Schalters S wird an der Induktivität L eine Spannung induziert. Ohne die Diode D bewirkt die Spannung einen steilen Spannungsanstieg am Schalter S, wodurch dieser Schaden nehmen kann. Selbst ohne bleibende Schäden entstehen im Schalter S, so er als Halbleiterschalter ausgeführt ist, hohe Verluste. Durch das Einfügen der Diode D, die mit ihrer Kathode an den Pluspol der Spannungsversorgung geschaltet ist, wird der Strom abgeleitet. Wenn der Schalter S leitend wird, bevor sich die Induktivität L über die Diode D entladen hat, liegt eine sogenannte nicht-lückende Betriebsweise vor. In diesem Fall muß der Schalter S neben dem eigentlichen Laststrom durch L den momentan in der Freilaufdiode D fließenden Strom übernehmen, wobei die volle Betriebsspannung und der Ausräumstrom der Freilaufdiode D gleichzeitig den Schalter S belasten. Die Verluste erhöhen u.a. die Sperrschichttemperatur, beispielsweise eines als Schalter S eingesetzten MOS-Transistors, und beeinflussen hierüber auch die Verluste während der Leitphase des Schalters S negativ.

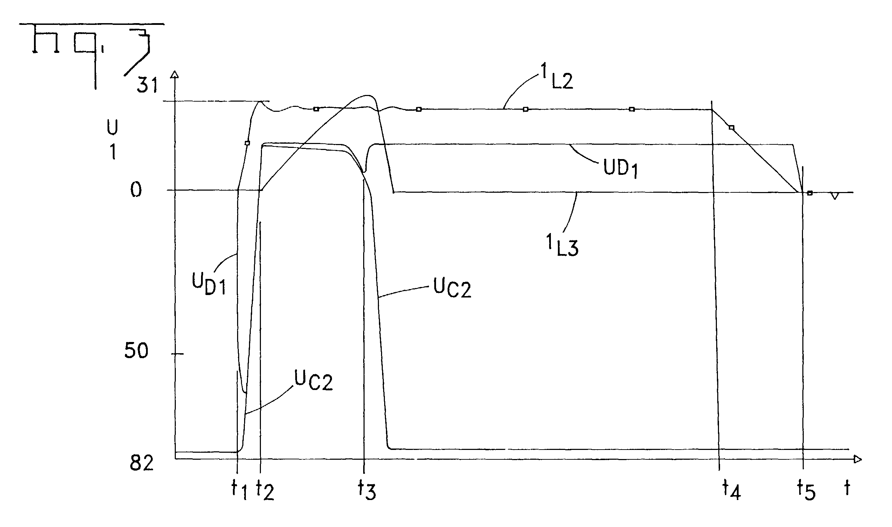

Die Figur 2 zeigt eine Schaltungsanordnung, die gemäß der Erfindung ausgeführt ist. In dieser Schaltungsanordnung ist ein Halbleiterschalter S1 bei nicht-lückender Betriebsweise von Einschaltverlusten weitgehend befreit. Hierzu ist in Reihe zu einer Freilaufdiode D1 eine zweite Induktivität L2 geschaltet. Diese Induktivität L2 entkoppelt den Schalter S1 und die Diode D1 derart, daß Spannungssprünge, aber keine Stromsprünge im Schalter S1 und in der Diode D1 möglich sind. Diese Induktivität L2 ist vergleichsweise klein gegen die Lastinduktivität L1.

Um den Spannungsanstieg am Schalter S1 zu Beginn der Sperrphase gezielt zu steuern, ist hier eine Anordnung vorgesehen, die mit C1 bezeichnet ist. In einem einfachen Fall besteht die Anordnung aus einem einfachen Kondensator C1. In einer Weiterbildung der Erfindung ist an dieser Stelle eine Schaltung eingesetzt, die die im Kondensator C1 gespeicherte Energie in die Energiequelle zurückspeisen kann.

An den Verbindungspunkt der zweiten Induktivität L2 und der Diode D1 ist ein zweiter steuerbarer Schalter S2 angekoppelt, an den andererseits direkt ein Kondensator C2 und über eine zweite Diode D2 eine dritte Induktivität L3 geschaltet sind. Der Kondensator C2 und die Induktivität L3 liegen andererseits am Bezugspotential, das das zweite Versorgungspotential darstellt.

Ferner ist eine Steuereineheit SE vorgesehen, die die Spannung über der Freilaufdiode D1 und den Schaltzustand des ersten Schalters S1 auswertet und aud dieser Grundlage den Schalter S2 steuert. Mittels dieser Steuerung wird der Schalter S2 halb-synchron mit dem Schalter S1 derart gesteuert, daß S2 leitend wird, wenn S1 sperrt, und daß S2 leitend bleibt, bis der Strom durch die Freilaufdiode D1 - von hohen Werten kommend - nahezu Null geworden ist, weil der Strom in den Induktivitäten L2 und L2 nahezu gleich groß ist.

Zur Erklärung der Funktionsweise der vorgeschlagenen Schaltungsanordnung wird vom eingeschwungenen Zustand ausgegangen und der Schalter S1 zunächst als leitend angenommen. Der eigentliche Zweck der vorgeschlagenen Anordnung liegt am Beginn der nächsten Leitphase.

Wenn S1 sperrt, wird der Strom im Lastpfad über R1 und L1 kurzzeitig von der Anordnung C1 aufgenommen und so der Spannungsanstieg du/dt an dem ersten Schalter S1 moderiert. Die Freilaufdiode D1 und die Induktivitäten L2 und L3 sind noch stromlos. Synchron mit S1 wird über S2 der negativ gegen Bezugspotential geladene Kondensator C2 an L2 geschaltet. Der Kondensator C2 entlädt sich nun in die zweite Induktivität L2 und bewirkt dort einen schnellen Stromanstieg. Bei Überschreiten des Bezugspotentials wird die dritte Induktivität L3 "mitgenommen", d.h. ein Strom fließt auch über die zweite Diode D2 und die dritte Induktivität L3. Durch geeignete Dimensionierung der Bauteile und ausreichende Ladung im Kondensator C2 wird gesichert, daß die Spannung am Kondensator C2 in dem Moment die Flußspannung der Freilaufdiode D1 erreicht, indem der Strom durch die zweite Induktivität L2 den Betrag des Stromes im Lastpfad erreicht. Die Spannung über dem ersten Schalter S1 ist nur geringfügig höher als die Betriebsspannung, daher geht der Laststrom von der Anordnung C1 "weich" auf die zweite Induktivität L2 über. Gleichzeitig geht der Strom von der Anordnung, bestehend aus dem Kondensator C2 und der Induktivität L3, auf die Freilaufdiode D1 über.

Die Spannung am Kondensator C2 steigt nicht mehr, aber die dritte Induktivität L3 zweigt nun ihrerseits über die Diode D2 zunehmend Strom ab, bis der über die zweite Induktivität L2 eingespeiste Laststrom nahezu vollständig in die dritte Induktivität L3 geleitet ist. Hierbei geht die Flußspannung an der Freilaufdiode D1 gegen Null. Dies wird von der Steuereinheit SE erfaßt, worauf sie kurz vor dem Nulldurchgang den Schalter S2 sperrt und anschließend der Laststrom zwangsweise wieder durch die Freilaufdiode D1 fließt. Der Kondensator C2 entlädt sich in die dritte Induktivität L3. Anschließend kommutiert die in der dritten Induktivität L3 gespeicherte Energie in den Kondensator C2 und lädt diesen auf die eingangs erwähnte hohe negative Spannung auf. Wenn die gesamte Energie der dritten Induktivität L3 im Kondensator C2 gespeichert ist, sperrt die Diode D2. Im Kondensator C2 ist so die Energie für die nächste Ladung von L2 zwischengespeichert.

Die zweite und die dritte Induktivität L2 und L3 sind etwa gleich groß, da mit dieser Selbststeuerung die benötigte Energie für die zweite Induktivität L2 erst im Kurzzeitspeicher L3 und danach im Langzeitspeicher C2 gespeichert wird. Der Anteil von C2 ist gering, weil er an die Betriebsspannung geklemmt wird und diese relativ klein gegen den Betrag der negativen Ladespannung ist. Sein Anteil deckt im Wesentlichen die Verluste. Diese Steuerung des zweiten Schalters S2 paßt daher den Energiebedarf für die zweite Induktivität L2 selbsttätig an eine pulsbreitenmodulierte Steuerung von dem ersten Schalter S1 an.

Wenn der erste Schalter S1 wieder leitend gesteuert wird, wird der Verbindungspunkt der ersten Induktivität L1 zur zweiten Induktivität L2 und dem ersten Schalter S1 an Bezugspotential gelegt. Die Anordnung C1 kommutiert die gespeicherte Energie beispielsweise in die Hauptenergiequelle zurück und der Strom in der zweiten Induktivität L2 und durch die Freilaufdiode D1 geht linear gegen null, da mit konstanter Spannung abkommutiert wird. In gleichem Maße steigt der Strom in S1 von Null linear bis zum Strom im Lastpfad an. Wenn die Diode D1 stromfrei ist, fällt die Spannung an ihr auf Bezugspotential und ein neuer Zyklus beginnt.

Die Figur 3 zeigt Strom- und Spannungsverläufe der Schaltungsanordnung von Figur 2, die dem Verständnis der Schaltung dienen. Deutlich ist, daß der negativ zum Bezugspotential geladene Kondensator C2 einen wesentlich höheren Spannungsbetrag als die Versorgungsspannung U1 aufweist.

Zum Zeitpunkt t1 sperrt der erste Schalter S1. Gleichzeitig wird der zweite Schalter S2 leitend, so daß sich der Kondensator C2 in die zweite Induktivität L2 entladen kann. In der Zeitspanne zwischen t1 und t2 ändert sich die Spannung über dem Kondensator C2 von der negativen Vorspannung bis auf Null. Gleichzeitig steigt der Strom durch L2 cosinusförmig an. Zum Zeitpunkt t2 ist das Strommaximum durch die zweite Induktivität L2 erreicht und die gesamte Energie des Kondensators C2 ist übertragen. Die zweite Induktivität L2 übernimmt nun den zuvor durch die Lastinduktivität L1 geflossenen Laststrom. Die Bauteile sind so dimensioniert, daß der Übergang sehr weich erfolgt. Der Strom durch L2 verzweigt sich und fließt zu einem Teil durch die Diode D1 und zu einem anderen Teil über die Diode D2 in die dritte Induktivität L3. Nachdem die dritte Induktivität L3 den gesamten Strom, der durch die zweite Induktivität L2 fließt, übernommen hat, fällt die Flußspannung an der Diode D1 stark ab. Kurz bevor sie den Wert Null erreicht, sperrt die Steuereinheit SE den zweiten Schalter S2, so daß der Strom durch L2 nun zwangsweise wieder durch D1 fließt. Die dritte Induktivität L3 entlädt sich nun in den Kondensator C2. Dieser wird dadurch auf die gegenüber dem Bezugspotential negative Spannung aufgeladen. Zum Zeitpunkt t4 wird der erste Schalter S1 wieder leitend gesteuert und der Strom durch die zweite Induktivität L2 geht linear gegen Null. In gleichem Maße steigt der Strom in S1 von Null linear bis zum Strom im Lastpfad an, wobei dies in der Figur 3 nicht dargestellt ist. Wenn der Strom durch die zweite Induktivität L2 zum Zeitpunkt t5 Null geworden ist, bricht die Flußspannung über der ersten Diode D1 zusammen. Der Ausgangszustand ist damit wiederhergestellt.

## Patentansprüche

1. Schaltungsanordnung mit
- einem ersten und einem zweiten Versorgungspotential (U1, 0),
- einem ersten Halbleiterschalter (S1), der mit dem zweiten Versorgungspotential (0) verbunden ist,
- einer ersten eine Last bildenden Induktivität (L1), die zwischen dem ersten Halbleiterschalter (S1) und dem ersten Versorgungspotential (U1) liegt,
- einem Parallelzweig zu der ersten Induktivität (L1), der eine erste Diode (D1) aufweist, deren Kathode (K) zu dem Versorgungspotential (U1) geschaltet ist, das gegenüber dem anderen Versorgungspotential (0) eine positive Spannung aufweist,
**dadurch gekennzeichnet, daß**
- der Parallelzweig eine zweite Induktivität (L2) aufweist, die in Reihe zu der ersten Diode (D1) geschaltet ist und mit dem Verbindungspunkt der ersten Induktivität (L1) mit dem ersten Schalter (S1) verbunden ist,
- an der Verbindungsstelle zwischen der ersten und der zweiten Induktivität (L1, L2) eine erste kapazitive Anordnung (C1) angekoppelt ist, die mit dem zweiten Versorgungspotential (0) verbunden ist,
- an der Verbindungsstelle zwischen der zweiten Induktivität (L2) und der ersten Diode (D1) ein zweiter Halbleiterschalter (S2) angeschlossen ist, der über eine Anordnung, die eine zweite Kapazität (C2) und parallel dazu eine Reihenschaltung aus einer zweiten Diode (D2) und einer dritten Induktivität (L3) aufweist, mit dem zweiten Versorgungspotential (0) verbunden ist, und
- einer Steuereinheit (SE), die den zweiten Schalter (S2) halbsynchron mit dem ersten Schalter (S1) derart steuert, daß der zweite Schalter (S2) leitend wird, wenn der erste Schalter (S1) sperrt, und leitend bleibt, bis der Strom durch die erste Diode (D1) einen vorbestimmten Schwellwert nahe Null unterschreitet.

2. Schaltungsanordnung nach Anspruch 1,
**dadurch gekennzeichnet, daß** die zweite und die dritte Induktivität (L2, L3) gleich groß sind.
